# EUROPÄISCHE PATENTSCHRIFT

(11) **EP 0 827 802 B1**
(45) Veröffentlichungstag und Bekanntmachung des Hinweises auf die Patenterteilung: **17.05.2000**
(21) Anmeldenummer: 97114138.7
(22) Anmeldetag: 16.08.1997
(51) Int. Cl.: B23K 26/00, B60R 21/20

(54) **Verfahren zur Herstellung einer Schwächelinie mittels Laser**
Method to produce a weakening line using a laser
Procédé pour réaliser une ligne de faible résistance au moyen d'un laser

(30) Priorität: 07.09.1996 DE 19636429
(43) Veröffentlichungstag der Anmeldung: 11.03.1998
(73) Patentinhaber: JENOPTIK Aktiengesellschaft, 07743 Jena (DE)
(72) Erfinder: Lutze, Walter, 07747 Jena (DE); Schmieder, Frank, 07616 Bürgel (DE); Schulze, Rainer, 07745 Jena (DE); Schwarze, Ralf, 21337 Lüneburg (DE); Schmidt, Wolfgang, 59494 Soest (DE)

(56) Entgegenhaltungen:
- EP-A- 0 711 627
- WO-A-90/07398
- DE-A- 4 320 341
- DE-A- 19 546 585
- US-A- 4 789 770
- US-A- 5 632 914
- PATENT ABSTRACTS OF JAPAN vol. 14, no. 305 (M-0992), 29.Juni 1990 & JP 02 099324 A (TOYOTA MOTOR CORP), 11.April 1990,
- PATENT ABSTRACTS OF JAPAN vol. 97, no. 5, 30.Mai 1997 & JP 09 001530 A (SUMITOMO KINZOKU ELECTRO DEVICE : KK), 7.Januar 1997,

## Beschreibung

Die Erfindung betrifft ein Verfahren zur Herstellung einer Schwächelinie in ein Flachmaterial durch einseitig örtliches Abtragen des Flachmaterials mittels steuerbarer gepulster Laserstrahlung. Das Flachmaterial kann eben oder auch räumlich geformt sein.
Es ist für viele Verwendungszwecke üblich, Materialschwächung in Linienform vorzunehmen, um eine Sollbruchlinie zu schaffen, die im Bedarfsfall durch Krafteinwirkung gebrochen wird, um die anliegenden Materialteile voneinander zu trennen oder eine Öffnung zu bilden. Es ist stets von Vorteil, wenn diese Sollbruchlinie über ihre Länge eine konstante Bruchfestigkeit aufweist, damit eine Trennung mit konstanter Kraft erfolgen kann. Für verschiedene Anwendungen ist es aus sicherheitstechnischen Gründen sogar erforderlich, daß die Bruchfestigkeit konstant und reproduzierbar herstellbar ist. Eine solche Anwendung ist beispielsweise eine Airbag-Abdeckung. Aus ästhetischen Gründen besteht hier teilweise noch die Forderung, daß die Sollbruchlinie für den Fahrzeuginsassen mit bloßem Auge nicht sichtbar sein soll.
Will man die Vorzüge der Lasermaterialbearbeitung zur Herstellung solcher Schwächelinien nutzen, stellt sich die Erfüllung der Forderungen nach einer reproduzierbaren , konstanten Bruchfestigkeit als schwierig dar.
Eine reproduzierbare, konstante Bruchfestigkeit erfordert im wesentlichen eine konstante und reproduzierbar herstellbare Restwandstärke im Bereich der Schwächelinie. Diese läßt sich über einen gleichmäßig tiefen Abtrag dann erreichen, wenn das Material eine konstante Dicke aufweist.
Doch selbst bei homogenen Materialien konstanter Dicke läßt sich eine definierte Restwandstärke mit einem ungesteuerten Bearbeitungslaser kaum erreichen. Schwankungen in der Strahlungsqualität und Strahlungsleistung führen zu entsprechenden Schwankungen in der Bearbeitungstiefe. Eine Steuerung des Lasers in Abhängigkeit von der Abtragstiefe wird erforderlich, was die Erfassung der Abtragstiefe voraussetzt.
Die Verwendung von mechanischem Meßmitteln und somit eine berührende Erfassung der Abtragstiefe scheidet schon aufgrund der geringen Schnittfugenbreiten aus.
Ebenso können elektrische oder magnetische Meßverfahren nicht angewendet werden bei der Bearbeitung elektrisch nichtleitender Materialien.
In der EP-A-0 711 627, die als nächstliegender Stand der Technik angesehen wird, ist ein Meßverfahren mittels Ultraschall vorgeschlagen.

In der DE 39 43 523 C2 wird ein Verfahren zum Abtragen, insbesondere metallischer Werkstücke mit Laserstrahlung, beschrieben. Erfindungsgemäß erfolgt hier eine Regelung der einwirkenden Laserstrahlungsintensität über ein Ein- und Abschalten des Lasers in Abhängigkeit der erfaßten Wärmestrahlung, was für höhere Bearbeitungsgeschwindigkeiten ungeeignet scheint. Zur Verbesserung der Genauigkeit wird die Abtragstiefe gemessen und für eine Grenzwertkorrektur herangezogen. In der Beschreibung der DE 39 43 523 C2 wird erläutert, daß die Messung der Abtragstiefe beispielsweise mit einem nach dem Triangulationsprinzip arbeitenden optischen Sensor erfolgt. Die Anwendbarkeit dieses Meßprinzips ist jedoch beschränkt auf Schnitte mit senkrechtem Verlauf, Schnittfugenbreiten größer dem Querschnitt des Meßstrahls und einen linearen Schnittverlauf. Darüber hinaus ist dieses Meßprinzip ebenso wie andere Meßprinzipien, welche die Abtragstiefe erfassen, nicht geeignet, um auf die verbleibende Restwandstärke zu schließen, sobald die Materialdicke nicht konstant ist.
Der Einfluß einer nicht konstanten Materialstärke auf die Bruchfestigkeit der Sollbruchlinie läßt sich nur durch einen in Abhängigkeit von der erfaßten Restwandstärke geregelten Abtrag ausschließen. Hier scheint sich eine Lösung gemäß DE 43 20 341 A1 anzubieten. Es wird ein Verfahren zum Abtragen von Deckschichten von Glasbauteilen mit Laserstrahlung offenbart, bei welchem der Abtragvorgang in Abhängigkeit von Transmissionswerten geregelt wird.
Hier besteht die Aufgabe darin, die Deckschicht eines Glasbauteils dahingehend gezielt und definiert abzutragen, daß eine Restdeckschicht mit vorgegebener Schichtdickenverteilung auf dem Glasbauteil zurückbleibt. Über die Messung des Transmissionsgrades an der Bearbeitungsstelle läßt sich auf die noch vorhandene Schichtdicke auf dem Glasbauteil schließen. Damit ist dieses Meßverfahren insbesondere geeignet für den Abtrag ungleichmäßiger Schichtdicken bis auf eine vorgegebene Restschichtdicke, ohne daß zuvor die Topologie der ungleichmäßigen Deckschicht ermittelt werden muß.
Zur Bestimmung der Restschichtdicke wird an der Bearbeitungsstelle die Intensität einer transmittierten Meßstrahlung nach jedem Bearbeitungslaserpuls gemessen und der Meßwert an einen Prozeßrechner weitergegeben. Durch Verknüpfung einzelner Meßwerte können verschiedene Bewertungskriterien, wie die Abtragseffizienz und relative Transmission, bestimmt werden. Der Meßwert als Einzelwert wird mit einem Schwellwert verglichen und dient bei dessen Überschreitung als Abschaltkriterium zur Beendigung des Abtragsvorganges.

Wie praktische Versuche gezeigt haben, läßt sich die Lösung gemäß DE 43 20 341 nicht mit Erfolg zur Erzeugung einer Schwächelinie in gewünschter Qualität anwenden. Im Gegensatz zum beschriebenen Abtragen von Deckschichten auf Glasbauteilen, wo der Abtrag flächig erfolgt und somit sich entstehende Verbrennungsrückstände und Verdampfungsgase sofort flächig verteilen und verflüchtigen, bleiben diese entstehenden Gase und Rückstände bei einem linienförmigen Abtrag, insbesondere bei wenn die Abtragsbreite wesentlich kleiner als die Abtragstiefe ist, am Abtragsort länger konzentriert und verfälschen durch ihre Absorption die Transmissionswerte.

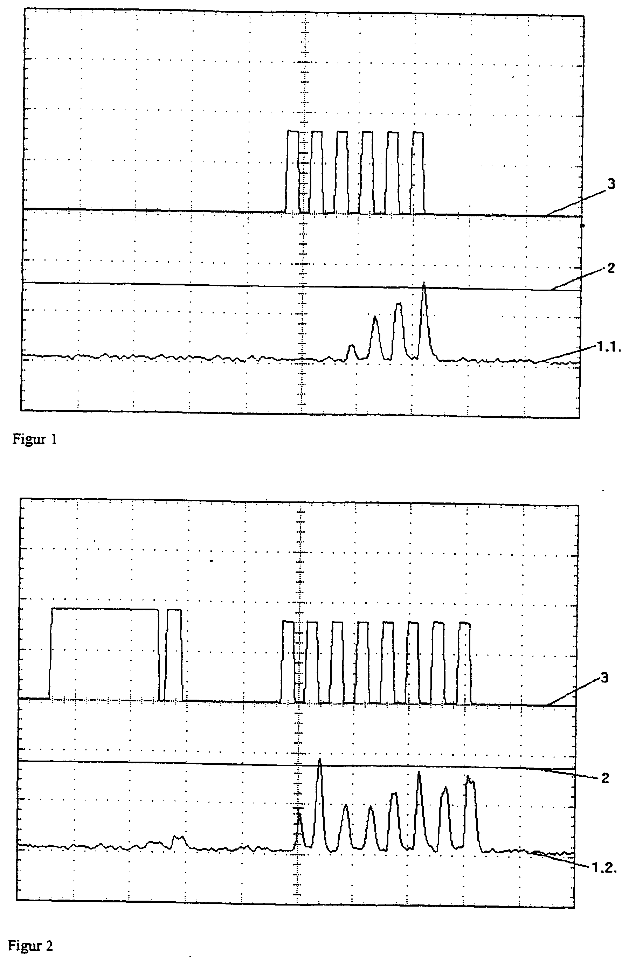

Zum besseren Verständnis sind in Fig. 1 und Fig. 2 zwei Meßwertdiagramme dargestellt. Der in Fig. 1 aufgezeichnete Detektorsignalverlauf 1.1 entspricht in etwa dem theoretischen Signalverlauf und entsteht z.B bei dem Abtragsvorgang an einem homogenen Material, bei welchem die Abtragsbreite sehr groß ist im Verhältnis zur Abtragstiefe und die Abtragsgeschwindigkeit gering ist. Nach Überschreitung des Rauschpegels steigt der Pegel des Detektorsignals 1.1 kontinuierlich an.
Im Gegensatz hierzu ist der Anstieg des Detektorsignalverlaufs 1.2, wie er bei einem linienförmigen Abtrag von inhomogenen Material entsteht unstetig, d.h. der Anstieg ist im wesentlichen diskontinuierlich, erfaßte Nachfolgesignale haben sogar teilweise einen niedrigeren Pegel als ihr Vorgängersignal. Daß der Anstieg des Detektorsignalverlaufes 1.2 nicht kontinuierlich ist, läßt sich u.a. mit den inhomogenen Materialeigenschaften des bearbeiteten Flachmaterials erklären, was bei gleichen Strahlungsparametern zu unterschiedlichen Abtragstiefen führt. Nicht erklären läßt sich damit der teilweise negative Anstieg bzw. Nullanstieg des Signalverlaufes.
Diese Erscheinung hat ihre Ursache im wesentlichen in der bereits erwähnten Entwicklung und Verdichtung entstehender Verbrennungsrückstände und Verdampfungsgase an der unmittelbaren Bearbeitungsstelle. Diese absorbieren die Laserstrahlung mit ihrer Verdichtung zunehmend, so daß der Signalpegel nicht mit der Abtragstiefe korreliert. Die Überschreitung des Schwellwertes 2 erfolgt abrupt, häufig erst nach unerwünschtem Durchbruch des Materials an der Bearbeitungsstelle. Eine mehrfache Wiederholung der Bearbeitung führt trotz gleicher Verfahrensparameter und Randbedingungen zu unterschiedlichen Signalverläufen. Der Grund dafür wird in der zeitlich und räumlich ungleichmäßigen Verteilung der Verbrennungsrückstände und Verdampfungsgase im entstandenen Materialgraben vermutet, was dadurch bestärkt wird, daß die Abweichungen des Detektorsignalverlaufes von dem Detektorsignalverlauf 1.1 mit zunehmender Bearbeitungsgeschwindigkeit größer werden. Eine Abschaltung des Lasers (Abbruch des Steuersignals 3) bei Überschreitung des Schwellwertes 2 durch den Signalpegel führt zu einer Sollbruchlinie stark schwankender Abtragstiefe.
Zur Erzeugung einer mit bloßem Auge nicht sichtbaren Sollbruchlinie konstanter Restwandstärke und damit konstanter und reproduzierbarer Bruchfestigkeit, ist dieses Verfahren aus den angeführten Gründen nicht geeignet.

Der Erfindung liegt die Aufgabe zugrunde, ein Verfahren zu entwickeln, mit welchem mittels steuerbarer gepulster Laserstrahlung eine mit bloßem Auge nicht sichtbare Schwächelinie reproduzierbarer und konstanter Bruchfestigkeit in einem Flachmaterial hergestellt werden kann.
Das Verfahren soll auch dann mit Erfolg anwendbar sein, wenn dieses Flachmaterial aus mehreren, auch inhomogenen Schichten besteht und in seiner Dicke nicht konstant ist.

Diese Aufgabe wird mit einem Verfahren zur Erzeugung einer Schwächelinie gemäß Anspruch 1 gelöst. Vorteilhafte Ausführungen sind in den Unteransprüchen angegeben.

Die Erfindung greift den aus dem Stand der Technik bekannten Grundgedanken auf, den Abtrag bis auf eine bestimmte Flachmaterialstärke über die Erfassung einer durch dieses Flachmaterial transmittierenden Strahlung zu steuern. Jedoch erst durch den erfindungsgemäßen Schritt der Integralwertbildung über die detektierte Transmissionsstrahlung wird ein Wert gewonnen, welcher trotz undefinierter Beeinflussung der Transmissionsstrahlung durch Materialinhomogenitäten und Ausbildung von Verbrennungsrückstände und Verdampfungsgasen gut mit der verbleibenden Restwandstärke korreliert. Dieses setzt jedoch voraus, daß die Schwächelinie keine Schnittfuge ist, sondern durch eine Aneinanderreihung von Sacklöchern gebildet wird. Mit den Sacklöchern werden örtlich begrenzte Räume geschaffen, in denen die entstehenden Gase zumindest über den kurzen Zeitraum der Bearbeitung fast vollständig verbleiben. Die Beeinflussung der Strahlung durch die absorbierenden Gase ist dadurch bei der Herstellung der einzelnen Sacklöcher gleich. Darüber hinaus wird durch den lochweisen Abtrag sicher gestellt, daß die detektierte Strahlung ausschließlich eine Transmissionsstrahlung durch den Boden des gerade bearbeiteten Sackloches ist. Gleiche Integralwerte lassen daher den Schluß auf wenigstens annähernd gleiche Restwandstärken zu.

Die Abschaltung der Laserstrahlung bei einer gewünschten Restwandstärke wird um so genauer, je besser das Signal-Rauschverhältnis und damit mehr Signale detektiert und zur Integralwertbildung herangezogen werden. Durch die Steuerung des Lasers in Abhängigkeit von einem Integralwert, werden auch die Materialinhomogenitäten relativiert, wodurch sich das Verfahren als besonders vorteilhaft für die Bearbeitung inhomogener Materialien eignet.

Die Herstellung einer Schwächelinie durch Abtrag des Flachmaterials in Form von Sacklöchern hat bezüglich der beiden Forderungen, konstante Bruchfestigkeit und Nichtsichtbarkeit, weitere Vorteile:
- während bei der Schaffung einer Schwächelinie durch Einschneiden nur die Restwandstärke in der Schnittfuge als geometrische Größe zur Erlangung einer bestimmten Bruchfestigkeit varriierbar ist, kann bei einer Aneinanderreihung von Sacklöchern (im weiteren Perforationslinie genannt) auch die Stegbreite zwischen den Sacklöchern variiert werden
- das Restmaterial muß beim Abtrag in Form einer Schnittlinie so stark sein, daß es sich nicht in die Schnittfuge einlegt und somit sichtbar wird. Dieses Einlegen wird bei der Perforationslinie auch bei weit geringeren Restwandstärken durch die als Stütze wirkenden Stege vermieden.
- eine über die gesamte Perforationslinie konstante Bruchfestigkeit läßt sich auch erzielen, wenn die Sacklöcher unterschiedliche Restwandstärken aufweisen, die sich periodisch wiederholen.

Insbesondere, wenn eine Schwächelinie in ein mehrschichtiges Verbundmaterial eingebracht werden soll, erweisen sich in Abhängigkeit der Festigkeit der einzelnen Schichten verschiedene Schwächelinienstrukturen, d.h. verschiedene Folgen von Restwandstärken, als mehr oder weniger vorteilhaft. So kann in mehrschichtigen Materialien, bei denen die einzelnen Materialschichten eine hohe Festigkeit aufweisen, die Schwächelinie in einer Struktur erzeugt werden, bei der sämtliche Sacklöcher eine gleiche minimale Restwandstärke aufweisen. Je geringer die Restwandstärke, desto geringer ist die Bruchfestigkeit des Flachmaterials, vorausgesetzt, die Materialkonstanten der Schichten und die Stegbreiten sind unverändert. Geringe Restwandstärken und schmale Stegbreiten führen jedoch zu einer starken thermischen Belastung, die ebenso wie Materialerschlaffungen infolge von Alterung dazu führen kann, daß sich das Restmaterial in die Sacklöcher einlegt und so die Schwächelinie auch von der unbearbeiteten Flachmaterialseite her sichtbar wird. Dies tritt besonders dann auf, wenn einzelne Materialschichten, insbesondere die unterhalb der Oberflächenschicht befindlichen Schichten so weich sind, daß die verbleibenden Stege ihrer Stützfunktion nicht mehr gerecht werden können. Um dieses zu vermeiden, erfolgt ein Abtrag im periodischen Wechsel auf verschiedene Tiefen, wodurch im weichen Material eine deutlich größere Stegbreite erhalten bleibt und die Oberflächenschicht thermisch geringer belastet wird. Die Reißfestigkeit der Schwächelinie wird dadurch unbedeutend erhöht, die Gefahr der entstehenden Sichtbarkeit der Schwächelinie jedoch vermieden.
Besonders vorteilhaft ist das erfindungsgemäße Verfahren, wenn die Schwächelinie in ein Verbundmaterial eingebracht wird, deren Oberflächenschicht räumlich strukturiert ist. Die Reißfestigkeit der Schwächelinie ist homogen trotz Schwankung der Materialstärke der Oberflächenschicht durch deren Strukturierung, da erfindungsgemäß auf eine definierte Restwandstärke abgetragen wurde. Vorteilhaft gegenüber einem Flachmaterial mit ebener unstrukturierter Oberfläche ist, daß Einschmiegungen des Restmaterials in die Sacklöcher schlechter durch das menschliche Auge wahrgenommen werden. Noch schlechter wahrnehmbar sind Einschmiegungen oder auch Durchbrüche, wenn die Schwächelinie nicht kontinuierlich verläuft. Schwächelinien, die mit bloßem Auge nicht erkennbar sein sollen, sind in der Regel nicht dazu vorgesehen, daß sie mit gezielter Krafteinwirkung in Linienrichtung gebrochen werden, sondern durch eine flächige einwirkende Kraft bricht das Flachmaterial entlang der Schwächelinien und schafft dadurch eine Öffnung im Flachmaterial. Üblich ist es, die Schwächelinie gleich der Umfangslinie der gewünschten Öffnung zu erzeugen. Um jedoch die Wahrscheinlichkeit des Sichtbarwerdens zu verringern, ist eine um diese Umfangslinie alternierender Schwächelinienverlauf von Vorteil. Dabei kann die Schwächelinie stochastisch um die Umfangslinie alternierend oder auch bei ähnlicher Oberflächenstruktur einer bestimmten Funktion folgend. Mit einer entsprechend groben Oberflächenstruktur und einem an diese angepaßten Schwächelinienverlauf können sogar die Sacklöcher der Schwächelinie mit einer Restwandstärke Null erzeugt werden, ohne daß diese mit bloßem Auge wahrgenommen werden können, sofern die Durchbrüche nur klein genug sind, was mittels Laser gut erreichbar ist.

Grundsätzlich kann das erfindungsgemäße Verfahren auf alle mit Laser bearbeitbaren Flachmaterialien angewendet werden, sofern wenigstens die Oberflächenschicht für wenigstens eine Laserwellenlänge transparent ist. Vorteilhafterweise ist dies die Wellenlänge des Bearbeitungslasers. Lediglich technisch aufwendiger, im wesentlichen aber ebenso realisierbar, ist eine zusätzliche Beaufschlagung des Bearbeitungsortes mit einer Meßstrahlung, deren transmittierender Anteil erfaßt wird.
Als Oberflächenschicht können Kunststoffe sowie Leder, Gummi, Kautschuk technische Textilien und papierähnliche Flachmaterialien vorteilhaft bearbeitet werden. Anstelle der Schaumstoffschicht und der Holzformschicht des ersten Ausführungsbeispiels kann die Oberflächenschicht auf verschiedene ein- oder mehrschichtige Flachmaterialien aufgebracht sein, wie beispielsweise Kunststoffverbundmaterialien und -laminate sowie Holz, Gummi, Kautschuk und Karton.

In einem ersten Ausführungsbeispiel ist das Flachmaterial ein Verbundmaterial, bestehend aus drei verschiedenen inhomogenen Materialschichten, einer festen, dem Verbundmaterial seine Stabilität gebenden Trägerschicht aus Holzformstoff, einer weichen Schaumschicht und einer dünnen TPO-Folie als Oberflächenschicht. Zur Erreichung der gewünschten Bruchfestigkeit wurde eine Schwächelinienstruktur ausgewählt mit abwechselnder Folge von je zwei Sacklöchern mit Restwandstärke a und je zwei Sacklöchern der Restwandstärke b bei konstanter Stegbreite c. Die Restwandstärke a, kleiner der Dicke der TPO-Folie wurde in Abhängigkeit der Materialparameter der TPO-Folie so festgelegt, daß die Folie teilweise abgetragen wird, jedoch das Restmaterial ausreichend stark ist, um auch über lange Zeit formstabil zu bleiben. Die Restwandstärke b, größer der Dicke der TPO-Folie wurde so festgelegt, daß die Trägerschicht vollständig durchdrungen wird, während in der Schaumschicht höchstens ein geringer Abtrag erfolgt. Dadurch bleibt der Schaum über größere Stegbreiten zur Stützung der Folie erhalten, während die Trägerschicht kontinuierlich geschwächt wird. Die Schaumschicht und die TPO-Folie weisen einen Transmissionsgrad für die Wellenlänge des Bearbeitungslasers von deutlich größer Null auf.
Zur Durchführung des erfindungsgemäßen Verfahrens wird ein in der Pulsleistung und Pulsfolge steuerbarer Laserstrahl auf das Verbundmaterial seitens der Trägerschicht gerichtet. Unterhalb des Verbundmaterials, seitens der TPO-Folie, ist in Richtung des Laserstrahls ausgerichtet, ein Sensor angeordnet, welcher den durch das Verbundmaterial transmittierenden Anteil des Laserstrahles detektiert. Die Parameter des Detektors und der Laserstrahlungsquelle sind so aufeinander abgestimmt, daß ein erstes Signal dann detektiert wird, wenn die Trägerschicht am Bearbeitungsort vollständig abgetragen ist. Zwischen dem Laserstrahl und dem Verbundmaterial erfolgt eine Relativbewegung in Richtung der zu erzeugenden Schwächelinie. Diese Relativbewegung kann entweder eine kontinuierliche Bewegung sein mit einer Geschwindigkeit vernachlässigbar gering zur Pulsfrequenz, kleiner der maximalen Abtragsgeschwindigkeit oder die Bewegung wird stets während der Beaufschlagung des Verbundmaterials mit der Laserstrahlung unterbrochen.

Die Bearbeitung des Verbundmaterials beginnt mit einem Pulsregime für hohe Pulsleistungen, was ein schnelles Durchdringen der Trägerschicht ermöglicht. Mit der Detektion eines ersten Signals wird das Pulsregime verändert, um es dem Abtragverhalten der Schaumstoffschicht anzupassen. Insbesondere wird die Pulsdauer kleiner gewählt, was eine geringe thermische Belastung zur Folge und Verlangsamung des Abtrages zur Folge hat. Je langsamer der Abtrag erfolgt, desto mehr Signale werden detektiert. Nach jedem Signalempfang wird über die bereits detektierten Signale ein Integral gebildet und der Integralwert mit einem Komparatorwert verglichen. Sobald der Integralwert den Komparatorwert erreicht, welcher in vorherigen Versuchen als Korrelationswert zur Restwandstärke a ermittelt wurde, wird die Laserstrahlung abgeschaltet. Analog wird das zweite Loch im Stegabstand c zum ersten Loch erzeugt. Bei der Erzeugung des dritten und vierten Loches wird die Laserstrahlung bereits dann abgeschaltet, wenn der gebildete Integralwert den Komparatorwert b erreicht. Da dessen Integralwert bereits nach Detektieren eines Signals oder nur weniger Signale erreicht wird, ist die Genauigkeit der verbleibenden Restwandstärke auch geringer. Dies ist jedoch nicht von Nachteil, da ein geringfügiges Eindringen in den Schaumstoff mit unterschiedlicher Tiefe keinen Einfluß auf die Bruchfestigkeit der Schwächelinie insgesamt hat.

## Patentansprüche

1. Verfahren zur Erzeugung einer Schwächelinie in ein Flachmaterial, durch einseitiges örtliches Abtragen des Flachmaterials mittels steuerbarer gepulster Laserstrahlung, wobei eine Relativbewegung zwischen der Laserstrahlung und dem Flachmaterial in Richtung der zu erzeugenden Schwächelinie erfolgt,
- wobei das Flachmaterial in Form von Sacklöchern abgetragen wird, die linienförmig aneinandergereiht angeordnet und untereinander jeweils durch einen Steg getrennt sind,
gekennzeichnet durch folgende Schritte:
- Detektion einer durch den Boden des jeweiligen Sacklochs transmittierenden Laserstrahlung nach jedem Laserpuls
- Integralwertbildung über die bei der Erzeugung eines Sackloches erhaltenen Detektorsignale nach jeder Detektion,
- Vergleich des Integralwertes mit einem für das jeweilige Sackloch vorgegebenen und mit der gewünschten Restwandstärke korrelierenden Sollwertes,
- Abschalten der Laserstrahlung bei Erreichen des Sollwertes
- Anschalten der Laserstrahlung nach erfolgter Relativbewegung über eine vorgegebene Strecke, welche für die gewünschte Stegbreite zwischen zwei benachbarten Sacklöchern bestimmend ist und Wiederholung der Verfahrensschritte, bis die Schwächelinie in vollständiger Länge erzeugt ist.

2. Verfahren zur Erzeugung einer Schwächelinie nach Anspruch 1, dadurch gekennzeichnet,
daß die detektierte Laserstrahlung ein Teil der Strahlung ist, welche den Abtrag bewirkt

3. Verfahren zur Erzeugung einer Schwächelinie nach Anspruch 1, dadurch gekennzeichnet,
daß die detektierte Laserstrahlung ein Teil einer zusätzlich auf das gerade bearbeitete Sackloch gerichteten Meßstrahlung ist.

4. Verfahren zur Erzeugung einer Schwächelinie nach Anspruch 1, dadurch gekennzeichnet,
daß die für die einzelnen Sacklöcher vorgegebenen Sollwerte eine wiederkehrende Folge unterschiedlicher Beträge bilden, wodurch in verschiedenen Materialtiefen verschiedene Stegbreiten herstellbar sind.

## Claims

1. Method for producing a line-shaped weakening in a flat material by local removal of material on one side of the flat material by means of controllable pulsed laser radiation, wherein a relative movement is effected between the laser beam and the flat material in the direction of the line-shaped weakening to be produced, wherein the flat material is removed in the form of blind holes which are arranged in series adjacent to one another in the shape of a line and are separated from one another in each instance by a web,
characterized by the following steps:
- detection of a laser beam transmitting through the bottom of the respective blind hole after each laser pulse,
- forming of integral value by way of the detector signals obtained during production of a blind hole after every detection,
- comparison of the integral value with a reference value which is predetermined for every blind hole and correlates with the desired residual wall strength,
- switching off of the laser radiation when the reference value is reached,
- switching on of the laser beam after completion of relative movement over a predetermined distance which determines the desired web width between two adjacent blind holes and repetition of the process steps until the line-shaped weakening is produced in its entire length.

2. Method for producing a line-shaped weakening according to claim 1, characterized in that the detected laser beam is a portion of the radiation which effects the removal of material.

3. Method for producing a line-shaped weakening according to claim 1, characterized in that the detected laser beam is part of a measurement beam which is additionally directed to the blind hole that has just been machined.

4. Method for producing a line-shaped weakening according to claim 1, characterized in that the reference values given for the individual blind holes form a recurring sequence of different amounts so that different web widths can be produced in different material depths.

## Revendications

1. Procédé pour réaliser une ligne de faible résistance dans un matériau plat par une érosion locale sur une face du matériau plat au moyen d'un faisceau laser pulsé réglable, dans lequel il se produit un mouvement relatif entre le faisceau laser et le matériau plat dans la direction de la ligne de faible résistance à réaliser, et dans lequel le matériau plat est érodé sous la forme de trous borgnes, qui sont disposés en ligne à la suite l'un de l'autre et qui sont séparés l'un de l'autre par une languette,
caractérisé par les étapes suivantes:
- après chaque impulsion du laser, détection d'un faisceau laser transmis à travers le fond du trou borgne respectif,
- après chaque détection, intégration des signaux du détecteur obtenus lors de la réalisation d'un trou borgne,
- comparaison de la valeur intégrale avec une valeur de consigne prédéterminée pour le trou borgne respectif et corrélée à l'épaisseur de paroi résiduelle désirée,
- coupure du faisceau laser lorsque la valeur de consigne est atteinte,
- allumage du faisceau laser après exécution du mouvement relatif sur une distance prédéterminée, qui est déterminante pour la largeur de languette désirée entre deux trous borgnes voisins et répétition des étapes du procédé, jusqu'à ce que la ligne de faible résistance soit réalisée sur toute sa longueur.

2. Procédé pour réaliser une ligne de faible résistance suivant la revendication 1, caractérisé en ce que le faisceau laser détecté est une partie du faisceau qui effectue l'érosion.

3. Procédé pour réaliser une ligne de faible résistance suivant la revendication 1, caractérisé en ce que le faisceau laser détecté est une partie d'un faisceau de mesure dirigé en plus vers le trou borgne qui vient d'être usiné.

4. Procédé pour réaliser une ligne de faible résistance suivant la revendication 1, caractérisé en ce que les valeurs de consigne prédéterminées pour les trous borgnes individuels forment une suite récurrente de valeurs différentes, grâce auxquelles on peut réaliser des largeurs de languettes différentes à différentes profondeurs du matériau.
